Europäisches Patentamt

European Patent Office

Office européen des brevets

(19)

(11) **EP 0 812 427 B1**

(12) **EUROPÄISCHE PATENTSCHRIFT**

(45) Veröffentlichungstag und Bekanntmachung des Hinweises auf die Patenterteilung:
**25.11.1998 Patentblatt 1998/48**

(21) Anmeldenummer: 96902797.8

(22) Anmeldetag: **27.02.1996**

(51) Int Cl.⁶: **G01R 31/02**

(86) Internationale Anmeldenummer:
**PCT/AT96/00030**

(87) Internationale Veröffentlichungsnummer:
**WO 96/27138 (06.09.1996 Gazette 1996/40)**

(54) **VERFAHREN ZUR ERKENNUNG EINES EINPOLIGEN ERDSCHLUSSES IN EINEM DREHSTROMNETZ**

UNIPOLAR EARTH LEAKAGE RECOGNITION PROCESS FOR THREE PHASE MAINS

PROCEDE DE RECONNAISSANCE DE PERTES MONOPOLAIRES A LA TERRE DANS UN RESEAU TRIPHASE

(84) Benannte Vertragsstaaten:
**AT CH DE FR IT LI SE**

(30) Priorität: **28.02.1995 AT 360/95**

(43) Veröffentlichungstag der Anmeldung:
**17.12.1997 Patentblatt 1997/51**

(73) Patentinhaber: **Haefely Trench Austria GmbH**
**4060 Leonding (AT)**

(72) Erfinder:
• **DRUML, Gernot**
**A-4203 Altenberg (AT)**

• **PAPP, Klaus**
**A-4040 Linz (AT)**

(74) Vertreter: **Weiser, Andreas et al**
**Patentanwälte Schütz u.Partner,**
**Fleischmanngasse 9**
**1040 Wien (AT)**

(56) Entgegenhaltungen:
**EP-A- 0 079 504        EP-A- 0 082 103**
**WO-A-92/18872        DE-B- 2 711 629**
**US-A- 5 309 109**

**Beschreibung**

Die vorliegende Erfindung betrifft ein Verfahren zur Erkennung eines einpoligen Erdschlusses auf einem Leitungsabgang in einem Drehstromnetz, das mit einer Erdschlußlöschspule zur Resonanzerdung des Sternpunktes betrieben wird, mit den Schritten:

(a) vektorielles Messen der Verlagerungsspannung des Sternpunktes und des Summenstromes des Leitungsabganges zu einem ersten Zeitpunkt, um ein erstes Meßwertepaar zu bilden;
(b) Verändern der Verlagerungsspannung über eine Zeitspanne, die einen zweiten Zeitpunkt einschließt, und vektorielles Messen der Verlagerungsspannung und des Summenstromes des Leitungsabganges zum zweiten Zeitpunkt, um ein zweites Meßwertepaar zu bilden.

Die bekannten Verfahren zur Erkennung einpoliger Erdschlüsse lassen sich im wesentlichen in zwei Gruppen unterteilen.

Die Verfahren der ersten Gruppe (siehe z.B. EP 0 082 103) beruhen auf der Annahme, daß die Summe aller ohmschen Ströme des Nullsystems über die Fehlerstelle fließt, so daß der Wirkanteil des Nullstromes eine den fehlerhaften Abgang bestimmende Größe ist. Bei hochohmigen Erschlüssen treten jedoch nur sehr kleine Wirkströme auf, die in der Meßungenauigkeit der Meßwandler untergehen, welche bei Wirkleistungs-Richtungsrelais etwa 1% beträgt. Zwar kann durch eine genaue Abstimmung der Bürde, Strom- und Winkelfehler der Meßwandler eine etwas größere Meßgenauigkeit erzielt werden, doch ist dies bei bestehenden Anlagen in der Praxis ausgesprochen schwierig und die Grenzen der Meßungenauigkeit sind auch hier bald erreicht.

Bei Wirkleistungs-Richtungsrelais als Meßwandler wird daher häufig das Verfahren der Reststromerhöhung angewandt, beispielsweise durch Einschalten eines ohmschen Widerstandes in das Nullsystem, um die Wirkkomponente künstlich zu erhöhen und das Ansprechen der Wirkleistungs-Richtungsrelais zu erleichtern. Bei hochohmigen Erdschlüssen ist aber der Strom über die Fehlerstelle im wesentlichen durch den Widerstand an der Fehlerstelle bestimmt, gegenüber welchem der für die Reststromerhöhung zugeschaltete Widerstand vernachlässigbar ist, so daß die Reststromerhöhung bei hochohmigen Erdschlüssen nicht den gewünschten Erfolg zeigt.

Ein abgewandeltes Verfahren ist in der US 5 309 109 beschrieben. Dabei wird durch erzwungenes Erden einer der gesunden Phasen der Summenstrom künstlich erhöht, um die Messung zu erleichtern. In der EP 0 079 504 ist ein anderes Verfahren beschrieben, bei welchem nicht nur das Nullsystem, sondern auch das Mit- und das Gegensystem überwacht werden, was entsprechend aufwendig ist.

Die zweite Gruppe von bekannten Verfahren beruht im wesentlichen auf der Annahme, daß über die Fehlerstelle ein der Über- oder Unterkompensation der Erdschlußlöschspule proportionaler Nullstrom fließt. Durch Verändern der Reaktanz, z.B. durch Verstimmen der Erdschlußlöschspule oder Zu- und Abschalten von Kapazitäten (auch als "Pulsortung" bekannt, siehe z.B. DE 27 11 629) und Beobachten des Summenstromes der einzelnen Abgänge kann ein fehlerhafter Abgang ermittelt werden.

Ein anderes Verfahren, das mit dieser Gruppe verwandt ist, ist in der WO 92/18872 beschrieben und verwendet die einleitend genannten Meßschritte, jedoch in gänzlich anderem Zusammenhang und für einen anderen Zweck. Bei dem Verfahren der WO 92/18872 werden aus den beiden Meßwertepaaren die Admittanzen jedes einzelnen Abganges vor und nach der Änderung der Verlagerungsspannung ermittelt, wobei eine Differenz von ungleich Null den fehlerbehafteten Abgang angibt. Mit dem Verfahren ist nur eine Identifizierung desjenigen Abgangs unter mehreren Abgängen, der fehlerbehaftet ist, im Falle eines bereits vorliegenden Erdschlusses möglich, nicht jedoch das Erkennen des Auftretens eines Erdschlusses. Das Verfahren funktioniert nicht bei sehr symmetrischen Netzen ($U_o <<$), und seine Identifizierungsschwelle ist durch die natürliche Unsymmetrie des Netzes begrenzt.

Auch die zweite Gruppe von Verfahren bzw. das damit verwandte Verfahren der WO 92/18872 arbeitet nur bei niederohmigen Erdschlüssen einwandfrei. Bei hochohmigen Fehlern ändert sich infolge der Impedanzänderung der Erschlußlöschspule auch die Verlagerungsspannung, so daß die größte Summenstromänderung nicht mehr im fehlerbehafteten Abgang, sondern in dem Abgang mit der größten Erdkapazität angezeigt wird. Ferner können diese Verfahren nur bei einer genügend großen Über- oder Unterkompensation ausgeführt werden, weil eine Verstimmung der Reaktanz in der Nähe des Resonanzpunktes nur zu sehr kleinen, nicht mehr erfaßbaren Stromänderungen führt, eine symmetrische Verstimmung um den Resonanzpunkt sogar zu überhaupt keiner Stromänderung.

Zusammengefaßt versagen alle bekannten Verfahren zur Erkennung von einpoligen Erdschlüssen bei hochohmigen Erdschlüssen. Als hochohmige Erdschlüsse werden definitionsgemäß Erdschlüsse mit einem Erdübergangswiderstand von größer als 5 kΩ bezeichnet, obwohl im allgemeinen Sprachgebrauch bereits Erdübergangswiderstände von größer als 1 kΩ als "hochohmig" bezeichnet werden, weil sie mit den bekannten Verfahren nicht mehr feststellbar sind. Hochohmige Erdschlüsse treten beispielsweise auf, wenn ein umgestürzter Baum eine Leitung berührt (40 kΩ bis 100 kΩ), ein Leiterseil nach einem Seilriß auf trockenen Sand, trockenen Felsen, Schnee oder Eis fällt, oder bei einem rückwärtigen Kabelbruch, bei welchem ein vom Verbraucher rückkehrendes Leiterseil zwar niederohmig die Erde berührt, jedoch von der Versorgerseite aus gesehen ein hochohmiger Erdschluß besteht, weil die Impedanz des verbraucherseitigen Transformators bzw. des Verbrauchers in den Erdschluß miteingeht.

Hochohmige Erdschlüsse sind jedoch sehr gefährlich. Zwar ist durch den hohen Widerstand der Strom an der Fehlerstelle reduziert, doch ergeben sich aus demselben Grund sehr hohe Schritt- und Berührspannungen. Gleichzeitig ist ein hochohmiger Erdschluß mit dem Auge kaum zu erkennen, weil der geringe Fehlerstrom keine mit dem Auge erkennbaren Schäden hervorruft.

Tatsächlich hat man sich bislang damit abgefunden, daß hochohmige Erdschlüsse wegen der Unzulänglichkeiten der bekannten Verfahren von der Versorgerseite her nicht erkennbar sind. Auch in modernen Versorgungsnetzen werden hochohmige Erdschlüsse weiterhin durch optische Erkennung, beispielsweise im Wege einer Streckenkontrolle, und Meldung per Telefon erkannt.

Die Erfindung setzt sich daher zum Ziel, ein Verfahren der einleitend genannten Art zu schaffen, welches in der Lage ist, hochohmige Erdschlüsse zu erkennen. Dieses Ziel wird erfindungsgemäß mit einem Verfahren der einleitend genannten Art erreicht, das sich auszeichnet durch die weiteren Schritte:

(c) Ermitteln der Erdadmittanz des Abganges und einer auf die Unsymmetrie des Abganges zurückzuführenden Unsymmetrieadmittanz als Innenadmittanz einer den Parallelschwingkreis aus Erdschlußlöschspule und Erdadmittanz speisenden, von der Phasenspannung des Drehstromnetzes gebildeten Spannungsquelle aus den beiden Meßwertepaaren und Speichern der ermittelten Werte als Referenzwerte;

(d) vektorielles Messen der Verlagerungsspannung des Sternpunktes und des Summenstromes des Leitungsabganges zu einem dritten Zeitpunkt, um ein drittes Meßwertepaar zu bilden;

(e) Ermitteln einer auf einen allfälligen Erdschluß zum dritten Zeitpunkt zurückzuführenden Fehleradmittanz als Innenadmittanz einer den Parallelschwingkreis aus Erdschlußlöschspule, Erdadmittanz und Unsymmetrieadmittanz speisenden, von der Phasenspannung des Drehstromnetzes gebildeten Spannungsquelle aus dem dritten Meßwertepaar unter Verwendung der gespeicherten Referenzwerte; und

(f) Anzeigen eines Erdschlusses, wenn die Fehleradmittanz einen vorgegebenen Betrag überschreitet.

Dieses Verfahren beruht auf einem völlig neuartigen Konzept. Erstmals werden direkt die relevanten Komponenten des Erdschlußkreises berechnet, wobei berücksichtigt wird, daß der Abgang im fehlerfreien Betrieb bereits eine bestimmte "natürliche" Unsymmetrie aufweist. Die hier definierten Kenngrößen für den Abgang, Erdadmittanz und Unsymmetrieadmittanz, werden im fehlerfreien Betrieb aus den ersten beiden Meßpunkten ermittelt und als Referenzwerte gespeichert. Dadurch kann eine zusätzliche, durch einen Erdschluß hervorgerufene Unsymmetrie durch einen Vergleich mit den Referenzwerten bestimmt werden. Bei dieser Art von Vergleichsmessung heben sich Meßfehler der Meßwandler auf. Aus diesem Grund und wegen der Tatsache, daß die dem Verfahren zu Grunde liegende Ersatzschaltbilddarstellung des Netzes sowohl die Erdkapazitäten als auch die Veränderung der Verlagerungsspannung berücksichtigt, ist das Verfahren in der Lage, hochohmige Erdschlüsse, z.B. im Bereich von 40 bis 100 k$\Omega$, zu erkennen. Das Verfahren stellt einen entscheidenden Durchbruch in der Schutztechnik dar.

Das beschriebene Verändern der Verlagerungsspannung zur Erzielung des zweiten Meßpunktes kann durch jede beliebige, in der Technik an sich bekannte Maßnahme herbeigeführt werden, z.B. durch Ändern der Impedanz der Erdschlußlöschspule, zusätzliche Beschaltung des Sternpunktes oder eines Phasenleiters, und/oder eine Stromeinspeisung in den Sternpunkt oder einen Phasenleiter.

Eine besonders bevorzugte Ausführungsform des erfindungsgemäßen Verfahrens, welche insbesondere eine kontinuierliche Überwachung eines Netzes ermöglicht, zeichnet sich dadurch aus, daß die Schritte (d) bis (f) für weitere, an die Stelle des dritten Zeitpunktes tretende Zeitpunkte periodisch, vorzugsweise alle 20 ms, wiederholt werden, bis ein Erdschluß angezeigt wird. Bei sehr rascher Wiederholung, z.B. alle 20 ms, können mit diesem Verfahren auch sehr kurze selbstverlöschende Erdschlüsse, sog. Erdschlußwischer, erkannt werden.

Eine weitere bevorzugte Ausführungsvariante besteht darin, daß im Falle der Anzeige eines Erdschlusses die Schritte (a) bis (c) wiederholt werden, um einen zweiten Satz von Referenzwerten zu erhalten, daß die aus dem ersten Referenzwert der Erdadmittanz ermittelte Erdkapazität mit der aus dem zweiten Referenzwert der Erdadmittanz ermittelten Erdkapazität verglichen wird, und daß im Falle einer signifikanten Differenz die Referenzwerte des zweiten Satzes, soferne der zweite Referenzwert der Unsymmetrieadmittanz innerhalb eines zulässigen Bereiches liegt, als neue Referenzwerte gespeichert werden und die vorangegangene Anzeige eines Erdschlusses aufgehoben wird, wogegen im Falle keiner signifikanten Differenz die Anzeige des Erdschlusses aufrechterhalten wird.

Diese Verfahrensvariante beruht auf der Erkenntnis, daß das Zu- oder Abschalten eines Leitungsabschnittes am Abgang eventuell auch eine Änderung der Unsymmetrie des Abganges, d.h. eine vermeintliche Fehleradmittanz, hervorruft, wobei in diesem Fall jedoch durch die Änderung der Leitungslänge auch eine entsprechende Änderung der Erdkapazität einhergehen muß. Mit dieser Verfahrensvariante kann daher zwischen einem bewußten Schaltvorgang am Abgang und einem Erdschlußfehler unterschieden werden.

Bevorzugt wird, wenn das Verfahren für mehrere Abgänge einer Sammelschiene durchgeführt wird, im Falle der Anzeige von Erdschlüssen auf mehreren Abgängen jener Abgang bestimmt und angezeigt, welcher den größten Betrag der Fehleradmittanz aufweist. Bei sehr niederohmigen Fehlern, d.h. sehr großen Werten der Verlagerungsspannung, ergeben sich Rückwirkungen des erdschlußbehafteten Abganges auf die fehlerfreien Abgänge. Die beschriebene Maßnahme dient dazu, auch in diesem Fall eine sichere Identifizierung des fehlerhaften Abganges zu gewährleisten.

In jedem Fall ist es besonders günstig, wenn das erfindungsgemäße Verfahren den weiteren Schritt des Bestimmens des erdschlußbehafteten Phasenleiters des Abganges durch Vergleichen des auf den Winkel der Verlagerungsspannung bezogenen Winkels der Fehleradmittanz mit den Winkeln der Phasen des Drehstromnetzes umfaßt. Dadurch läßt sich nicht nur das Auftreten eines Erdschlusses auf einem Abgang feststellen, sondern auch jener Phasenleiter des Abganges, welcher dem Erdschluß unterliegt.

Die Erfindung wird nachstehend an Hand eines Ausführungsbeispieles näher erläutert, welches unter Bezugnahme auf die begleitenden Zeichnungen beschrieben wird, in denen

Fig. 1 das Blockschaltbild einer Meßanordnung zur Durchführung des erfindungsgemäßen Verfahrens zeigt,
Fig. 2 das vereinfachte Ersatzschaltbild eines Drehstromsystems mit induktiv geerdetem Sternpunkt, einem Abgang und einem hochohmigen Fehler,
die Fig. 3 bis 5 Überführungen und Vereinfachungen des Schaltbildes von Fig. 2,
Fig. 6 eine Erweiterung des Schaltbildes von Fig. 5 und
Fig. 7 beispielhafte Werte für $Y_u$ und $Y_f$ in der komplexen Ebene.

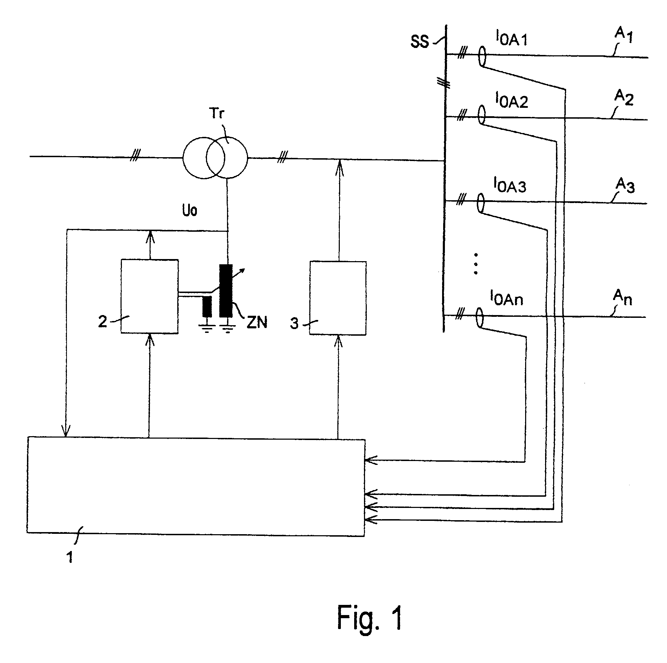

Fig. 1 zeigt die bei dem Verfahren zum Einsatz kommende Meßanordnung in Verbindung mit einem Drehstromnetz, welche einen Transformator Tr, eine Sammelschiene SS und Abgänge $A_1$ bis $A_{11}$ umfaßt. Der Sternpunkt des Transformators ist über eine Erdschlußlöschspule ZN geerdet (Petersen-Spule). Die an der Erdschlußlöschspule ZN auftretende Verlagerungsspannung $U_o$ wird vektoriell, d.h. nach Betrag und Phase bzw. Real- und Imaginärteil, gemessen und einer Meß- und Steuereinrichtung 1 zugeführt. An den Abgängen $A_1$ bis $A_{11}$ werden die Nullströme bzw. Summenströme $I_{0A1}$ bis $I_{0An}$ ebenfalls vektoriell gemessen und der Meß- und Steuereinrichtung 1 zugeführt.

Die Meß- und Steuereinrichtung 1 steuert eine Einrichtung 2 zur Änderung der Impedanz der Erdschlußlöschspule ZN und/oder eine Einrichtung 3 zur zusätzlichen Beschaltung des Sternpunktes und/oder einer der Phasen des Drehstromnetzes, um eine vorübergehende Änderung der Verlagerungsspannung $U_o$ zu bewirken. Beispielsweise kann die Impedanz der Erdschlußlöschspule ZN direkt durch Verstellen des Luftspaltes verändert werden, oder die Sekundärseite der Erdschlußlöschspule mit einem ohmschen Widerstand, einer Induktivität, einem Kondensator oder einer definierten Stromeinspeisung beschaltet werden, was durch die Einrichtung 2 angedeutet ist, und/oder es kann der Sternpunkt oder eine Phase L1, L2 oder L3 mit einem ohmschen Widerstand, einer Induktivität, einem Kondensator oder einer definierten Stromeinspeisung beschaltet werden, wie es durch die Einrichtung 3 angedeutet ist. Derartige Maßnahmen bzw. Einrichtungen sind dem Fachmann bekannt, so daß sie nicht näher erläutert oder dargestellt werden müssen.

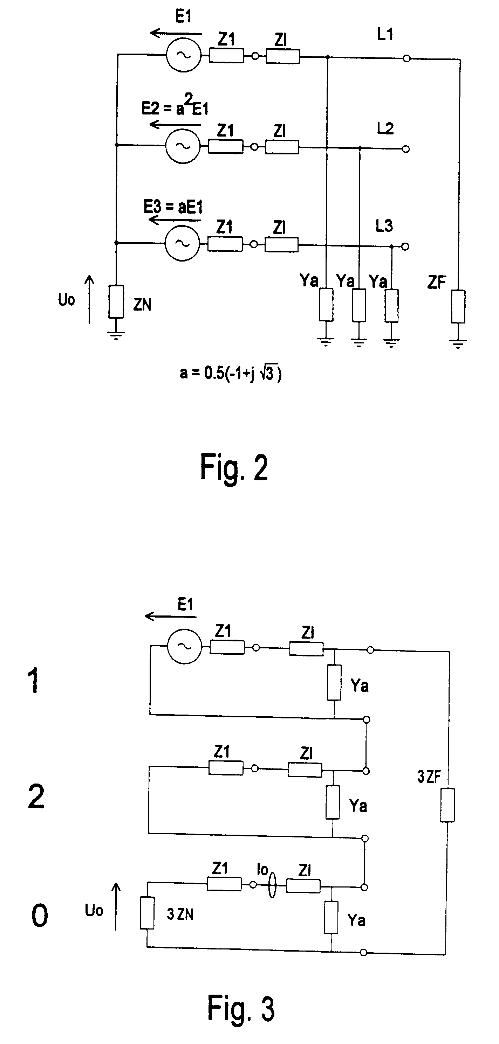

Fig. 2 zeigt das vereinfachte Ersatzschaltbild des Drehstromnetzes von Fig. 1, wobei nur ein Abgang dargestellt ist, in dem ein hochohmiger Erdschluß in der Phase L1 angenommen wird. ZN ist die Impedanz der Erdschlußlöschspule, Z1 sind die symmetrischen unabhängigen Selbstimpedanzen der drei Spannungsquellen E1, E2 und E3, welche zueinander um 120° versetzt sind, Z1 ist die Längsimpedanz der Leitung, $Y_a$ sind die Admittanzen der drei Phasenleiter L1, L2 und L3 gegen Erde, welche im wesentlichen aus den Erdkapazitäten der Phasenleiter bestehen, und ZF ist der komplexe Widerstand an der Fehlerstelle.

Durch Anwendung des Verfahrens der symmetrischen Komponenten kann das Ersatzschaltbild von Fig. 2 in das Symmetrische Komponentenersatzschaltbild aus Nullsystem 0, Mitsystem 1 und Gegensystem 2 übergeführt werden, welches in Fig. 3 dargestellt ist. Es ist ersichtlich, daß der Summenstrom $I_o$ im Nullsystem gemessen wird.

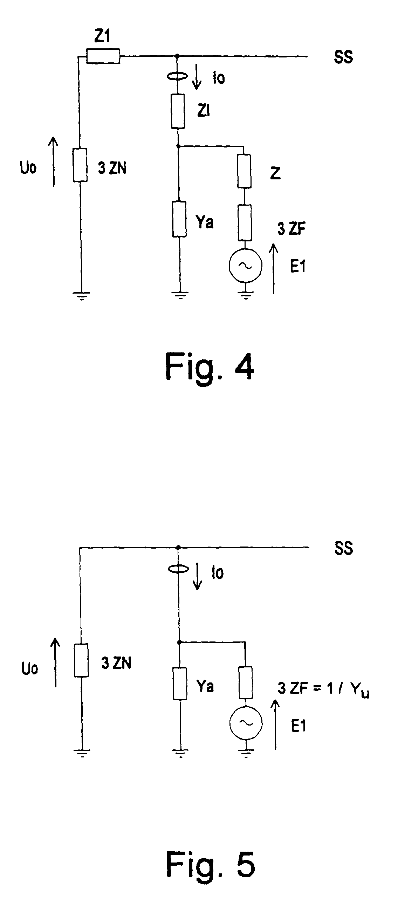

Durch Vernachlässigung der Erdadmittanten $Y_a$ im Mit- und Gegensystem 1, 2 sowie Zusammenfassung der Längsimpedanzen Zl im Mit- und Gegensystem 1, 2 kann das Schaltbild von Fig. 3 zu dem Schaltbild von Fig. 4 vereinfacht werden. Bei hochohmigen Fehlern (ZF>>) können ferner Zl und Z1 vernachlässigt werden, so daß sich das Ersatzschaltbild von Fig. 5 ergibt.

Aus Fig. 5 ist ersichtlich, daß die Fehlerimpedanz 3ZF als Innenimpedanz einer Spannungsquelle E1 aufgefaßt werden kann, welche den parallelen Schwingkreis aus Erdschlußlöschspule 3ZN und Erdadmittanz $Y_a$ speist.

Es wird in weiterer Folge die Annahme getroffen, daß selbst im erdschlußfreien Fall eine bestimmte "natürliche" Unsymmetrie des Abganges vorhanden ist, die sich ebenfalls durch das Schaltbild von Fig. 5 beschreiben läßt, wobei die "natürliche" Unsymmetrie durch eine Unsymmetrieadmittanz $Y_u$ angegeben werden kann, welche die Innenimpedanz der den Parallelschwingkreis aus ZN und $Y_a$ treibenden Spannungsquelle E1 darstellt.

Das Schaltbild von Fig. 5 enthält damit zwei unbekannte Werte, $Y_a$ und $Y_u$. Werden $U_o$ und $I_o$ zu zwei verschiedenen Zeitpunkten t1 und t2 vor und nach einer aktiven, mit Hilfe der Einrichtung 2 und/oder 3 bewirkten Änderung von $U_o$ gemessen, können zwei Gleichungen für zwei Unbekannte aufgestellt werden:

$$I_{o1} = \left(U_{o1} - |E1|e^{j(\varphi U_{o1} - 90)}\right)Y_u + U_{o1}Y_a \qquad\qquad (\text{Gl.1})$$

$$I_{o2} = \left(U_{o2} - |E1|e^{j(\varphi U_{o1} - 90)}\right)Y_u + U_{o2}Y_a \qquad\qquad (\text{Gl.2})$$

E1 wird senkrecht zu $U_o$ angenommen, weil die natürliche Unsymmetrie als hauptsächlich kapazitiv bedingt angenommen wird. Die Annahme ist jedoch nicht zwingend; die richtige Phasenlage ergibt sich am Ende der Berechnung.

Die Lösung der Gleichungen 1 und 2 liefert komplexe Gleichungen für die Erdadmittanz $Y_a$ und die Unsymmetrieadmittanz $Y_u$:

$$Y_a = \frac{I_{o2}U_{o1} - U_{o2}I_{o1} + |E1|e^{j(\varphi U_{o1} - 90)}\left(I_{o1} - I_{o2}\right)}{|E1|e^{j(\varphi U_{o1} - 90)}\left(U_{o1} - U_{o2}\right)} \qquad\qquad (\text{Gl.3})$$

$$Y_u = \frac{U_{o2}I_{o1} - U_{o1}I_{o2}}{|E1|e^{j(\varphi U_{o1} - 90)}\left(U_{o1} - U_{o2}\right)} \qquad\qquad (\text{Gl.4})$$

Die Erdkapazität $C_e$ des Abganges entspricht dem Imaginärteil von $Y_a$:

$$\omega C_e = imag(Y_a) \qquad\qquad (\text{Gl.5})$$

Weil $Y_u$ als Kenngröße der natürlichen Unsymmetrie als kapazitiver Blindleitwert angenommen werden kann, zeigt die Phase von $Y_u$ die tatsächliche Phasenlage der einspeisenden Spannungsquelle E1 der natürlichen kapazitiven Unsymmetrie an.

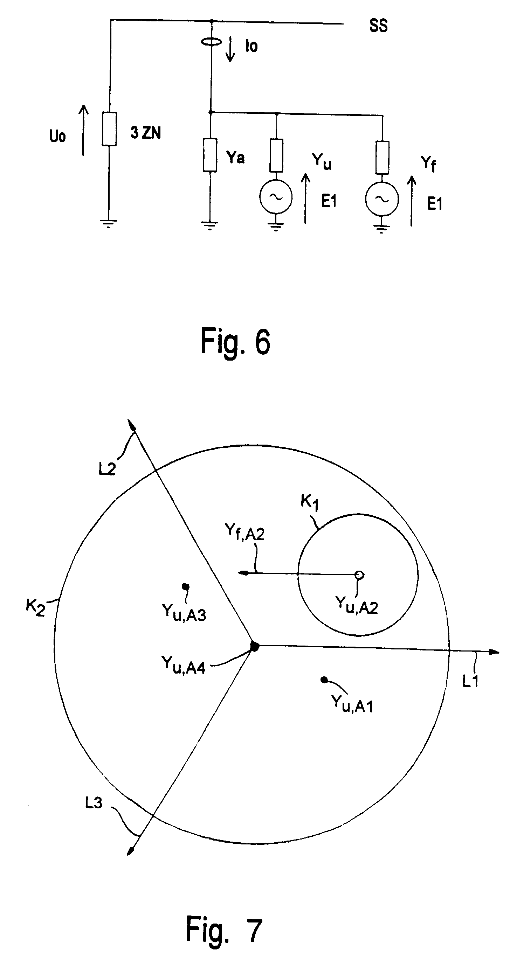

Durch einen Vergleich der Unsymmetrieadmittanz $Y_u$ mit einem vorgegebenen Schwellwert K2 (siehe später zu Fig. 7) wird der Bereich abgegrenzt, für den die Annahme gilt, daß die Verlagerungsspannung $U_o$ nur durch die natürliche kapazitive Unsymmetrie des Netzes verursacht wird. Überschreitet die Unsymmetrieadmittanz $Y_u$ den Schwellwert K2, so wird bereits in diesem Berechnungsschritt der Abgang als erdschlußbehaftet erkannt.

Wird hingegen der Schwellwert K2 nicht überschritten, so werden die berechneten Werte $Y_a$ und $Y_u$ als Referenzwerte für die weitere Überwachung verwendet.

Für den Fall, daß zu einem dritten Zeitpunkt $t_3$ ein hochohmiger Erdschluß auf dem Abgang auftritt, kann das Ersatzschaltbild von Fig. 5 zu dem Ersatzschaltbild von Fig. 6 erweitert werden. Der hochohmige Fehler bewirkt eine zusätzliche Speisung des Parallelschwingkreises aus Erdschlußlöschspule ZN, Erdadmittanz $Y_a$ und Unsymmetrieadmittanz $Y_o$ durch eine Spannungsquelle E1, welche den Betrag der Phasenspannung hat, über eine zunächst als komplex betrachtete Fehleradmittanz $Y_f$.

Durch Messen der Werte von $U_o$ und $I_o$ zum dritten Zeitpunkt t3 kann folgende Gleichung aufgestellt werden:

$$I_{o3} = \left(U_{o3} - |E1|e^{j(\varphi U_{o1} - 90)}\right)Y_u + U_{o3}Y_a + \left(U_{o3} - |E1|e^{j(\varphi U_{o3} - \varphi U_{o1} + 90)}\right)Y_f \qquad\qquad (\text{Gl.6})$$

In Verbindung mit den Gleichungen 1 und 2 ergibt sich ein Gleichungssystem aus drei Gleichungen für drei Unbekannte, welches für $Y_a$ die Lösung Gleichung 3, für $Y_o$ die Lösung Gleichung 4 und für $Y_f$ folgende Lösung liefert:

$$Y_f = \frac{U_{o1}(I_{o2} - I_{o3}) + U_{o2}(I_{o3} - I_{o1}) + U_{o3}(I_{o1} - I_{o2})}{\left(|E1|e^{j(\varphi U_{o3} - \varphi U_{o1} + 90)} - U_{o3}\right)(U_{o1} - U_{o2})} \qquad (Gl.7)$$

Unter der Annahme, daß die Fehlerstelle ein rein ohmscher Widerstand ist, gibt der Betrag von $Y_f$ die Größe des hochohmigen Fehlers und der Winkel von $Y_f$, korrigiert um den Winkel von $U_o$, die Phase L1, L2 oder L3 an, in welcher der Fehler zu finden ist. Dies wird an Hand des Diagrammes von Fig. 7 veranschaulicht.

In Fig. 7 sind die ermittelten Referenzwerte der natürlichen Unsymmetrie $Y_u$ von vier Abgängen $A_1$ bis $A_4$ in der komplexen Ebene dargestellt. Beim Auftreten eines hochohmigen Fehlers verschiebt sich die Unsymmetrie des fehlerbehafteten Abganges $A_2$ um einen Vektor, der gleich der Fehleradmittanz $Y_f$ ist. Der Betrag des Vektors ist umgekehrt proportional zum Widerstand des Erdschlusses, und die Richtung des Vektors gibt, verglichen mit den Richtungen der Phasen L1, L2 und L3, die Phase an, in welcher der Erdschluß auftritt. Im speziellen ist der um den Winkel der Verlagerungsspannung $U_o$ verminderte Winkel der Fehleradmittanz $Y_f$ antiparallel zu dem Winkel der erdschlußbehafteten Phase. Bei dem gezeigten Beispiel befindet sich der Erdschluß auf dem Phasenleiter der Phase L1 des Abganges $A_2$.

In Fig. 7 ist mit K1 ist der Toleranzkreis des Betrages dargestellt, den die Fehleradmittanz $Y_f$ überschreiten muß, damit ein Fehler angezeigt wird.

Mit K2 ist der Toleranzkreis angedeutet, in dem die Referenzwerte der natürlichen Unsymmetrie $Y_u$ liegen müssen, damit ein Abgang nicht schon nach der Bestimmung der Referenzwerte als erdschlußbehaftet erkannt wird.

Es ist zu beachten, daß durch Zu- und Abschalten eines Leitungsabschnittes in einem Abgang ebenfalls eine Änderung der Unsymmetrie hervorgerufen wird, die sich in einem Unsymmetrieadmittanzwert $Y_f$ äußert, welcher die Grenzen des Kreises K1 überschreiten kann. In diesem Fall kann durch eine nochmalige Bestimmung der Werte von $Y_a$ und $Y_u$ an Hand von Gleichung 5 festgestellt werden, ob sich bei dieser Änderung auch die Erdkapazität $C_e$ geändert hat. Ist die Erdkapazität $C_e$ gleichgeblieben, d.h. die Leitungslänge des Abganges nicht verändert worden, liegt ein Erdschlußfehler vor. Hat sich hingegen die Erdkapazität $C_e$ auf einen neuen Wert $C_{e2}$ geändert, und liegt der neue Wert der Unsymmetrieadmittanz $Y_{u2}$ innerhalb des Toleranzkreises K2, so werden die neu ermittelten Werte $Y_{a2}$ und $Y_{u2}$ als neue Referenzwerte $Y_a$ und $Y_u$ für die weitere Überwachung übernommen.

Wird das Verfahren für mehrere Abgänge einer gemeinsamen Sammelschiene durchgeführt, wie in Fig. 8 veranschaulicht ist, ergeben sich bei sehr niederohmigen Fehlern, d.h. sehr großen Werten von $U_o$, Rückwirkungen auf die fehlerfreien Abgänge. Um dennoch eine eindeutige Identifizierung des fehlerbehafteten Abganges zu gewährleisten, erfolgt in diesem Fall ein gegenseitiger Vergleich der Fehleradmittanzen $Y_f$ der einzelnen Abgänge, und der Abgang mit dem größten Betrag von $Y_f$ wird als fehlerhafter Abgang identifiziert.

Es ist ersichtlich, daß das beschriebene Verfahren nach einer einmaligen Bestimmung der Referenzwerte für $Y_a$ und $Y_u$ periodisch zu beliebigen späteren Zeitpunkten zur Berechnung von $Y_f$ unter Verwendung der gespeicherten Referenzwerte von $Y_a$ und $Y_o$ wiederholt werden kann, um eine laufende Überwachung des bzw. der Abgänge zu ermöglichen. Bevorzugt wird $Y_f$ alle 20 ms bestimmt, so daß auch kurze selbstverlöschende Erdschlüsse erkannt werden können.

Das erfindungsgemäße Verfahren kann mit Hilfe einer entsprechend programmierten Meß- und Steuereinrichtung 1 automatisch durchgeführt werden. Die Implementierung des beschriebenen Verfahrens als Programm ist dem Fachmann hinlänglich bekannt und muß nicht näher erläutert werden.

Die Erfindung ist selbstverständlich nicht auf das dargestellte Ausführungsbeispiel beschränkt, sondern umfaßt vielmehr alle Ausführungsformen, die im Rahmen der anschließenden Ansprüche liegen.

**Patentansprüche**

1. Verfahren zur Erkennung eines einpoligen Erdschlusses auf einem Leitungsabgang in einem Drehstromnetz, das mit einer Erdschlußlöschspule zur Resonanzerdung des Sternpunktes betrieben wird, mit den Schritten:

   (a) vektorielles Messen der Verlagerungsspannung des Sternpunktes und des Summenstromes des Leitungsabganges zu einem ersten Zeitpunkt ($t_1$), um ein erstes Meßwertepaar ($U_{o1}$, $I_{o1}$) zu bilden;
   (b) Verändern der Verlagerungsspannung über eine Zeitspanne, die einen zweiten Zeitpunkt ($t_2$) einschließt, und vektorielles Messen der Verlagerungsspannung und des Summenstromes des Leitungsabganges zum zweiten Zeitpunkt ($t_2$), um ein zweites Meßwertepaar ($U_{o2}$, $I_{o2}$) zu bilden; gekennzeichnet durch die Schritte:
   (c) Ermitteln der Erdadmittanz ($Y_a$) des Abganges und einer auf die Unsymmetrie des Abganges zurückzuführenden Unsymmetrieadmittanz ($Y_u$) als Innenadmittanz einer den Parallelschwingkreis aus Erdschlußlöschspule und Erdadmittanz ($Y_a$) speisenden, von der Phasenspannung des Drehstromnetzes gebildeten Spannungsquelle aus den beiden Meßwertepaaren ($U_{o1}$, $I_{o1}$; $U_{o2}$, $I_{o2}$) und Speichern der ermittelten Werte ($Y_a$, $Y_u$) als Referenzwerte;

(d) vektorielles Messen der Verlagerungsspannung des Sternpunktes und des Summenstromes des Leitungsabganges zu einem dritten Zeitpunkt ($t_3$), um ein drittes Meßwertepaar ($U_{o3}$, $I_{o3}$) zu bilden;

(e) Ermitteln einer auf einen allfälligen Erdschluß zum dritten Zeitpunkt ($t_3$) zurückzuführenden Fehleradmittanz ($Y_f$) als Innenadmittanz einer den Parallelschwingkreis aus Erdschlußlöschspule, Erdadmittanz ($Y_a$) und Unsymmetrieadmittanz ($Y_u$) speisenden, von der Phasenspannung des Drehstromnetzes gebildeten Spannungsquelle aus dem dritten Meßwertepaar ($U_{o3}$, $I_{o3}$) unter Verwendung der gespeicherten Referenzwerte ($Y_a$, $Y_u$); und

(f) Anzeigen eines Erdschlusses, wenn die Fehleradmittanz ($Y_f$) einen vorgegebenen Betrag (K1) überschreitet.

2. Verfahren nach Anspruch 1, dadurch gekennzeichnet, daß die Schritte (d) bis (f) für weitere, an die Stelle des dritten Zeitpunktes ($t_3$) tretende Zeitpunkte periodisch, vorzugsweise alle 20 ms, wiederholt werden, bis ein Erdschluß angezeigt wird.

3. Verfahren nach Anspruch 1 oder 2, dadurch gekennzeichnet, daß im Falle der Anzeige eines Erdschlusses die Schritte (a) bis (c) wiederholt werden, um einen zweiten Satz von Referenzwerten ($Y_{a2}$, $Y_{u2}$) zu erhalten, daß die aus dem ersten Referenzwert der Erdadmittanz ($Y_a$) ermittelte Erdkapazität ($C_e$) mit der aus dem zweiten Referenzwert der Erdadmittanz ($Y_{a2}$) ermittelten Erdkapazität ($C_{e2}$) verglichen wird, und daß im Falle einer signifikanten Differenz die Referenzwerte des zweiten Satzes, soferne der zweite Referenzwert der Unsymmetrieadmittanz ($Y_{u2}$) innerhalb eines zulässigen Bereiches (K2) liegt, als neue Referenzwerte ($Y_a$, $Y_u$) gespeichert werden und die vorangegangene Anzeige eines Erdschlusses aufgehoben wird, wogegen im Falle keiner signifikanten Differenz die Anzeige des Erdschlusses aufrechterhalten wird.

4. Verfahren nach einem der Ansprüche 1 bis 3, welches für mehrere Abgänge einer Sammelschiene durchgeführt wird, dadurch gekennzeichnet, daß im Falle der Anzeige von Erdschlüssen auf mehreren Abgängen jener Abgang bestimmt und angezeigt wird, welcher den größten Betrag der Fehleradmittanz ($Y_f$) aufweist.

5. Verfahren nach einem der Ansprüche 1 bis 4, gekennzeichnet durch den weiteren Schritt (g) des Bestimmens des erdschlußbehafteten Phasenleiters des Abganges durch Vergleichen des auf den Winkel der Verlagerungsspannung ($U_o$) bezogenen Winkels der Fehleradmittanz ($Y_f$) mit den Winkeln der Phasen (L1, L2, L3) des Drehstromnetzes.

## Claims

1. Method for identifying a single-pole earth fault on a line outlet in a three-phase network, which is operated with an earth fault neutraliser coil for the resonance earthing of the neutral point, having the steps:

(a) vector measurement of the offset voltage of the neutral point and of the sum-current of the line outlet at a first instant ($t_1$) in order to form a first pair of measured values ($U_{o1}$, $I_{o1}$);

(b) changing the offset voltage over a period of time encompassing a second instant ($t_2$) and vector measurement of the offset voltage and of the sum-current of the line outlet at the second instant ($t_2$) in order to form a second pair of measured values ($U_{o2}$, $I_{o2}$), characterised by the steps:

(c) determination of the earth admittance ($Y_a$) of the outlet and of an asymmetric admittance ($Y_u$), attributable to the asymmetry of the outlet as the internal admittance of a voltage source supplying the parallel oscillating circuit composed of the earth fault neutraliser coil and earth admittance ($Y_a$) and formed from the phase voltage of the three-phase network, from the two pairs of measured values ($U_{o1}$, $I_{o1}$; $U_{o2}$, $I_{o2}$) and storage of the determined values ($Y_a$, $Y_u$) as reference values;

(d) vector measurement of the offset voltage of the neutral point and of the sum-current of the line outlet at a third instant ($t_3$) in order to form a third pair of measured values ($U_{o3}$, $I_{o3}$);

(e) determination of a fault admittance ($Y_f$) attributable to any possible earth fault at the third instant ($t_3$) as the internal admittance of a voltage source supplying the parallel oscillating circuit composed of the earth fault neutraliser coil, earth admittance ($Y_a$) and asymmetric admittance ($Y_u$) and formed from the phase voltage of the three-phase network, from the third pair of measured values ($U_{o3}$, $I_{o3}$) using the stored reference values ($Y_n$, $Y_u$); and

(f) display of an earth fault if the fault admittance ($Y_f$) exceeds a predetermined value (K1).

**2.** Method according to Claim 1, characterised in that the steps (d) to (f) are repeated periodically, preferably every 20 ms, for further instants replacing the third instant ($t_3$) until an earth fault is displayed.

**3.** Method according to Claim 1 or 2, characterised in that in the event of the display of an earth fault the steps (a) to (c) are repeated in order to obtain a second set of reference values ($Y_{a2}$, $Y_{u2}$), that the earth capacitance ($C_e$) determined from the first reference value of the earth admittance ($Y_a$) is compared with the earth capacitance ($C_{e2}$) determined from the second reference value of the earth admittance ($Y_{a2}$), and that in the event of a significant difference the reference values of the second set are stored as new reference values ($Y_a$, $Y_u$) provided the second reference value of the asymmetric admittance ($Y_{u2}$) lies within a permitted range (K2) and the preceding display of an earth fault is cancelled, whereas in the event of no significant difference the display of the earth fault is maintained.

**4.** Method according to one of Claims 1 to 3, which is carried out for several outlets of a bus, characterised in that in the event of the display of earth faults on several outlets that outlet is determined and displayed which exhibits the largest value for the fault admittance ($Y_f$).

**5.** Method according to one of Claims 1 to 4, characterised by the further step (g) of determining the outlet phase conductor affected by the earth fault by comparing the angle of the fault admittance ($Y_f$) with reference to the angle of the offset voltage ($U_o$) with the angles of the phases (L1, L2, L3) of the three-phase network.

**Revendications**

**1.** Procédé pour identifier une perte unipolaire à la terre sur un départ de ligne dans un réseau triphasé, qui fonctionne avec une bobine de Petersen pour la mise à la terre à résonance du neutre, comprenant les étapes suivantes :

(a) mesure vectorielle de la tension de décalage du neutre et du courant somme du départ de ligne à un premier instant ($t_1$), pour former un premier couple de valeurs de mesure ($U_{o1}$, $I_{o1}$) ;

(b) modification de la tension de décalage pendant un intervalle de temps qui inclut un second instant ($t_2$), et mesure vectorielle de la tension de décalage et du courant somme du départ de ligne à l'instant ($t_2$), pour former un second couple de valeurs de mesure ($U_{o2}$, $I_{o2}$) ; caractérisé par les étapes suivantes :

(c) détermination de l'admittance à la terre ($Y_a$) du départ de ligne et d'une admittance de dissymétrie ($Y_u$), imputable à la dissymétrie du départ de ligne, en tant qu'admittance interne d'une source de tension, alimentant le circuit oscillant parallèle formé par la bobine de Petersen et l'admittance de terre ($Y_a$) et est formée par la tension de phase du réseau triphasé, à partir des deux couples de valeurs de mesure ($U_{o1}$, $I_{o1}$ ; $U_{o2}$, $I_{o2}$) et mémorisation des valeurs déterminées ($Y_a$, $Y_u$) en tant que valeurs de référence ;

(d) mesure vectorielle de la tension de décalage du neutre et du courant somme du départ de ligne à un troisième instant ($t_3$), pour former un troisième couple de valeurs de mesure ($U_{o3}$, $I_{o2}$) ;

(e) détermination d'une admittance d'erreur ($Y_f$), imputable à une éventuelle fuite à la terre au troisième instant ($t_3$), en tant qu'admittance interne d'une source de tension alimentant le circuit oscillant parallèle formé par la bobine de Petersen, l'admittance de terre ($Y_a$) et l'admittance de dissymétrie ($Y_u$) et formée par la tension de phase du réseau triphasé, à partir du troisième couple de valeurs de mesure ($U_{o3}$, $I_{o3}$) moyennant l'utilisation des valeurs de référence ($Y_a$ $Y_u$) mémorisées ; et

(f) affichage d'une fuite à la terre, lorsque l'admittance d'erreur ($Y_f$) dépasse une valeur absolue prédéterminée (K1).

**2.** Procédé selon la revendication 1, caractérisé en ce que les étapes (d) à (f) sont répétées périodiquement, de préférence toutes les 20 ms, pour d'autres instants apparaissant à la place du troisième instant ($t_3$), jusqu'à ce qu'une fuite à la terre soit affichée.

**3.** Procédé selon la revendication 1 ou 2, caractérisé en ce que dans le cas de l'affichage d'une fuite à la terre, les étapes (a) à (c) sont répétées pour l'obtention d'un second ensemble de valeurs de référence ($Y_{a2}$, $Y_{u2}$), que la capacité de terre ($c_e$) déterminée à partir de la première valeur de référence de l'admittance de terre ($Y_a$) est comparée à la capacité de terre ($c_{e2}$) déterminée à partir de la deuxième valeur de référence de l'admittance de terre ($Y_{a2}$) et que dans le cas d'une différence importante, les valeurs de référence du second ensemble sont mémorisées en tant que nouvelles valeurs de référence ($Y_{a2}$, $Y_u$) dans la mesure où la seconde valeur de référence de l'admittance de dissymétrie ($Y_{u2}$) se situe dans une gamme admissible (K2), et l'affichage précédent d'une fuite à la terre est supprimé, alors que dans le cas de l'absence d'une différence significative, l'affichage de la fuite à la terre est maintenu.

4. Procédé selon l'une des revendications 1 à 3, qui est mise en oeuvre pour plusieurs départs de lignes d'une même barre omnibus, que dans le cas de l'affichage de fuites à la terre sur plusieurs départs, le départ, pour lequel l'admittance d'erreur ($y_f$) possède la valeur absolue la plus grande, est déterminée et affichée.

5. Procédé selon l'une des revendications 1 à 4, caractérisé par l'étape suivante (g) de détermination du conducteur de phase affecté d'une fuite à la terre, du départ de ligne par comparaison de l'angle, rapporté à l'angle de la tension de décalage ($U_o$), de l'admittance d'erreur ($Y_f$) aux angles des phases (L1, L2, L3) du réseau triphasé.

Fig. 1

Fig. 2

Fig. 3

# Fig. 4

# Fig. 5

Fig. 6

Fig. 7